# EUROPÄISCHE PATENTSCHRIFT

(11) **EP 3 876 157 B1**
(45) Veröffentlichungstag und Bekanntmachung des Hinweises auf die Patenterteilung: **14.12.2022**
(21) Anmeldenummer: 20160370.1
(22) Anmeldetag: 02.03.2020
(51) Int. Cl.: G06N 3/04, G06N 3/08, B60W 60/00, B60W 30/00

(54) **COMPUTERIMPLEMENTIERTES VERFAHREN UND SYSTEM ZUM ERZEUGEN SYNTHETISCHER SENSORDATEN UND TRAININGSVERFAHREN**
COMPUTER-IMPLEMENTED METHOD AND SYSTEM FOR GENERATING SYNTHETIC SENSOR DATA AND TRAINING METHOD
PROCÉDÉ ET SYSTÈME MIS EN UVRE PAR ORDINATEUR PERMETTANT DE GÉNÉRER DES DONNÉES DE CAPTEUR SYNTHÉTIQUE ET PROCÉDÉ D'APPRENTISSAGE

(43) Veröffentlichungstag der Anmeldung: 08.09.2021
(73) Patentinhaber: dSPACE GmbH, 33102 Paderborn (DE)
(72) Erfinder: Hasenklever, Daniel, 33102 Paderborn (DE)

(56) Entgegenhaltungen:
- DE-A1-102017 006 155
- DE-A1-102017 116 017
- US-A1- 2019 004 533
- VASILY MORZHAKOV: "Sets of autoencoders with shared latent spaces", ARXIV.ORG, CORNELL UNIVERSITY LIBRARY, 201 OLIN LIBRARY CORNELL UNIVERSITY ITHACA, NY 14853, 6. November 2018 (2018-11-06), XP081046751,
- BELTRAN JORGE ET AL: "A Method for Synthetic LiDAR Generation to Create Annotated Datasets for Autonomous Vehicles Perception", 2019 IEEE INTELLIGENT TRANSPORTATION SYSTEMS CONFERENCE (ITSC), IEEE, 27. Oktober 2019 (2019-10-27), Seiten 1091-1096, XP033668550, DOI: 10.1109/ITSC.2019.8917176 [gefunden am 2019-11-27]
- TIM ALLAN WHEELER ET AL: "Deep Stochastic Radar Models", ARXIV.ORG, CORNELL UNIVERSITY LIBRARY, 201 OLIN LIBRARY CORNELL UNIVERSITY ITHACA, NY 14853, 31. Januar 2017 (2017-01-31), XP080752628, DOI: 10.1109/IVS.2017.7995697

## Beschreibung

Die vorliegende Erfindung betrifft ein computerimplementiertes Verfahren zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Anspruch 1.

Die Erfindung betrifft des Weiteren ein System zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Anspruch 12.

Die vorliegende Erfindung betrifft überdies ein Computerprogramm nach Anspruch 13 und einen computerlesbaren Datenträger nach Anspruch 14.

### Stand der Technik

Grafische Benutzeroberflächen zum Testen hochautomatisierter Fahrfunktionen eines Kraftfahrzeugs weisen in der Regel eine Mehrzahl von Komponenten auf, welche eine Verwaltung von Parametersätzen, eine Erstellung einer virtuellen Fahrzeugumgebung sowie eine Experimentverwaltung ermöglichen.

Ein Szenenaufbau der virtuellen Fahrzeugumgebung, d.h. eine Definition statischer und dynamischer Objekte einer Szene, erfolgt dabei durch Konfiguration und Import von in einer Objektbibliothek hinterlegten Objekten.

In der Regel sind beispielsweise zur Erzeugung von LiDAR-Daten aufwendige Testfahrten in einer Realumgebung erforderlich, um die entsprechenden Daten zu gewinnen. Daher ist es wünschenswert, LiDAR-Sensordaten synthetisch zu erzeugen. Eine LiDAR-Punktwolke beinhaltet im Wesentlichen zwei Merkmale, die Intensität von Objekten und die Distanz von Objekten zum LiDAR-Sensor.

Während die Distanz vergleichsweise einfach durch Geometrie modellierbar ist, beruht die Intensität auf Reflektivitätswerten von Materialien, die wiederum abhängig vom Einfallswinkel und der Art der Reflexion sind.

Um die Intensität in einer virtuellen Umgebung modellieren zu können, müssen daher die Materialeigenschaften der zu modellierenden Objekte eingemessen werden. Das Einmessen von Materialien ist einerseits kostenaufwendig und andererseits nur in endlicher Anzahl möglich.

Gleichzeitig ist das Modellieren von Messrauschen und Sensor-Rauschprofilen auf modellbasierter Art und Weise sehr komplex. Die Realität der synthetischen Daten ist begrenzt durch Faktoren wie realistische Oberflächenstruktur, Rauschen, Multipath-Ausbreitung und fehlendem Wissen über Materialeigenschaften. Die Offenbarung US 2019/004533 A1 (HUANG YU [US] ET AL), 3. Januar 2019, betrifft ein computerimplementiertes Verfahren zum Erzeugen von überlagerte Distanzinformationen aufweisenden synthetischen Sensordaten eines Umfelderfassungssensors, insbesondere eines LiDAR-Sensors, eines Fahrzeugs. Die Offenbarung VASILY MORZHAKOV: "Sets of autoencoders with shared latent spaces",ARXIV.ORG, CORNELL UNIVERSITY LIBRARY, 201 OLIN LIBRARY CORNELL UNIVERSITY ITHACA, NY 14853, 6. November 2018, diskutiert eine hierarchische Architektur von variational Autoencodern mit geteilten latenten Merkmalsräumen.

Demzufolge besteht ein Bedarf, bestehende Verfahren und Systeme zum Erzeugen synthetischer Sensordaten eines Umfelderfassungssensors, insbesondere eines LiDAR-Sensors, eines Fahrzeugs dahingehend zu verbessern, dass eine vereinfachte, effizientere und kostengünstigere Erzeugung der virtuellen Fahrzeugumgebung ermöglicht wird.

Es ist daher Aufgabe der Erfindung, ein computerimplementiertes Verfahren, ein System, ein computerimplementiertes Trainingsverfahren, ein Computerprogramm und einen computerlesbaren Datenträger anzugeben, welche eine vereinfachte, effizientere und kostengünstigere Erzeugung synthetischer Sensordaten eines Umfelderfassungssensors, insbesondere eines LiDAR-Sensors, eines Fahrzeugs ermöglichen.

### Offenbarung der Erfindung

Die Aufgabe wird erfindungsgemäß gelöst durch ein computerimplementiertes Verfahren zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Patentanspruch 1.

Die Aufgabe wird erfindungsgemäß ferner gelöst durch ein System zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Patentanspruch 13.

Die Aufgabe wird ferner gelöst durch ein Computerprogramm nach Patentanspruch 13 und einen computerlesbaren Datenträger nach Patentanspruch 14.

Die Erfindung betrifft ein computerimplementiertes Verfahren zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Anspruch 1.

Das Verfahren umfasst ein Bereitstellen eines hierarchischen variational bzw. variationalen Autoencoders, welcher eine erste Hierarchieebene, eine zweite Hierarchieebene und eine dritte Hierarchieebene aufweist oder dazu eingerichtet ist, mit der dritten Hierarchieebene eines externen variational Autoencoders zu kommunizieren.

Das Verfahren umfasst des Weiteren ein Empfangen eines Distanzinformationen aufweisenden ersten Datensatzes von Sensordaten, insbesondere synthetisch erzeugter und/oder real erfasster Sensordaten, des Umfelderfassungssensors des Fahrzeugs durch einen variational Autoencoder der ersten Hierarchieebene, welcher globale Merkmale des ersten Datensatzes von Sensordaten einem ersten Codebuch-Vektor zuordnet, wobei die globalen Merkmale (GM) in den Sensordaten enthaltenen Objekte, die als solche erkannt werden darstellen.

Das Verfahren umfasst ferner ein Empfangen des ersten Datensatzes von Sensordaten des Umfelderfassungssensors des Fahrzeugs durch einen variational Autoencoder der zweiten Hierarchieebene, welcher lokale Merkmale des ersten Datensatzes von Sensordaten einem zweiten Codebuch-Vektor zuordnet, wobei die lokalen Merkmale (LM) Feinmerkmale der in den Sensordaten enthaltenen Objekten darstellen.

Das Verfahren umfasst darüber hinaus ein Konditionieren eines durch den variational Autoencoder der ersten Hierarchieebene kodierten ersten Merkmalsvektors und eines durch den variational Autoencoder der zweiten Hierarchieebene kodierten zweiten Merkmalsvektors mit einem Distanz- und Intensitätsinformationen aufweisenden zweiten Datensatz von Sensordaten des Umfelderfassungssensors des Fahrzeugs.

Das Verfahren umfasst des Weiteren ein Zusammenführen des konditionierten ersten Merkmalsvektors und des konditionierten zweiten Merkmalsvektors zu einem resultierenden dritten Merkmalsvektor, und ein Dekodieren des resultierenden dritten Merkmalsvektors zum Erzeugen eines überlagerte Distanz- und Intensitätsinformationen aufweisenden dritten Datensatzes synthetischer Sensordaten des Umfelderfassungssensors des Fahrzeugs. Die synthetischen Sensordaten des Umfelderfassungssensors des Fahrzeugs sind eine computergenerierte Repräsentation der sensorbasiert erfassten realen Fahrzeugumgebung.

Die Erfindung betrifft des Weiteren ein System zum Erzeugen von überlagerte Distanz- und Intensitätsinformationen aufweisenden synthetischen Sensordaten eines Umfelderfassungssensors, insbesondere eines LiDAR-Sensors, eines Fahrzeugs nach Anspruch 12.

Das System umfasst einen Computer konfiguriert zur Implementierung eines hierarchischen variational Autoencoder, welcher eine erste Hierarchieebene, eine zweite Hierarchieebene und eine dritte Hierarchieebene aufweist oder dazu eingerichtet ist, mit der dritten Hierarchieebene eines externen variational Autoencoders zu kommunizieren.

Der hierarchische variational Autoencoder ist dazu eingerichtet, einen Distanzinformationen aufweisenden ersten Datensatz von Sensordaten, insbesondere synthetisch erzeugte und/oder real erfasste Sensordaten, des Umfelderfassungssensors des Fahrzeugs durch einen variational Autoencoder der ersten Hierarchieebene, welcher globale Merkmale des ersten Datensatzes von Sensordaten einem ersten Codebuch-Vektor zuordnet, zu empfangen, wobei die globalen Merkmale (GM) in den Sensordaten enthaltenen Objekte, die als solche erkannt werden darstellen.

Der hierarchische variational Autoencoder ist dazu eingerichtet, den ersten Datensatz von Sensordaten des Umfelderfassungssensors des Fahrzeugs durch einen variational Autoencoder der zweiten Hierarchieebene, welcher lokale Merkmale des ersten Datensatzes von Sensordaten einem zweiten Codebuch-Vektor zuordnet, zu empfangen, wobei die lokalen Merkmale (LM) Feinmerkmale der in den Sensordaten enthaltenen Objekten darstellen.

Der hierarchische variational Autoencoder ist ferner dazu eingerichtet, einen durch den variational Autoencoder der ersten Hierarchieebene kodierten ersten Merkmalsvektor und einen durch den variational Autoencoder der zweiten Hierarchieebene kodierten zweiten Merkmalsvektor mit einem Distanz- und Intensitätsinformationen aufweisenden zweiten Datensatz von Sensordaten des Umfelderfassungssensors des Fahrzeugs zu konditionieren.

Darüber hinaus ist der hierarchische variational Autoencoder dazu eingerichtet, den konditionierten ersten Merkmalsvektor und den konditionierten zweiten Merkmalsvektor zu einem resultierenden dritten Merkmalsvektor zusammenzuführen.

Ferner ist der hierarchische variational Autoencoder dazu eingerichtet, den resultierenden dritten Merkmalsvektor zum Erzeugen eines überlagerte Distanz- und Intensitätsinformationen aufweisenden dritten Datensatzes synthetischer Sensordaten des Umfelderfassungssensors des Fahrzeugs zu dekodieren.

Die Offenbarung betrifft überdies das Bereitstellen eines trainierten Algorithmus maschinellen Lernens zum Erzeugen von überlagerte Distanz- und Intensitätsinformationen aufweisenden synthetischen Sensordaten eines Umfelderfassungssensors, insbesondere eines LiDAR-Sensors, eines Fahrzeugs.

Die Offenbarung umfasst ein Bereitstellen eines hierarchischen variational Autoencoders, welcher zumindest eine erste Hierarchieebene und eine zweite Hierarchieebene aufweist.

Die Offenbarung umfasst ferner ein Empfangen von Eingabe-Trainingsdaten und Ausgabe-Trainingsdaten eines ersten autoregressiven künstlichen neuronalen Netzes, insbesondere eines künstlichen neuronalen Faltungsnetzes, der ersten Hierarchieebene.

Die Offenbarung umfasst des Weiteren ein Trainieren des ersten autoregressiven künstlichen neuronalen Netzes, insbesondere des künstlichen neuronalen Faltungsnetzes, der ersten Hierarchieebene zum Zuordnen von globalen Merkmalen der Eingabe-Trainingsdaten zu einem ersten Codebuch-Vektor.

Die Offenbarung umfasst ferner ein Empfangen von Eingabe-Trainingsdaten und Ausgabe-Trainingsdaten eines zweiten autoregressiven künstlichen neuronalen Netzes, insbesondere eines künstlichen neuronalen Faltungsnetzes, der zweiten Hierarchieebene.

Darüber hinaus umfasst die Offenbarung ein Trainieren des zweiten autoregressiven künstlichen neuronalen Netzes, insbesondere des künstlichen neuronalen Faltungsnetzes, der zweiten Hierarchieebene zum Zuordnen von lokalen Merkmalen der Eingabe-Trainingsdaten zu einem zweiten Codebuch-Vektor, wobei das zweite autoregressive künstliche neuronale Netz der zweiten Hierarchieebene durch das autoregressive künstliche neuronale Netz der ersten Hierarchieebene konditioniert wird.

Eine Idee der vorliegenden Erfindung ist es, durch vorstehend beschriebene Algorithmusstruktur mit einem hierarchischen variational Autoencoder sowie einer zusätzlichen Konditionierungsschicht einen vorgegebenen Datensatz synthetischer Sensordaten, insbesondere LiDAR-Daten, welcher Distanzinformationen enthält, derart zu transformieren, dass durch die Konditionierung des vorgegebenen Datensatzes mit einem weiteren Datensatz bestehend sowohl aus Distanz- als auch Intensitätsdaten eines Fahrzeugsensors ein transformierter bzw. verbesserter Datensatz erzeugbar ist, welcher eine Approximation von überlagerten Distanz- und Intensitätsinformationen aufweisenden synthetischen Sensordaten des Umfelderfassungssensors des Fahrzeugs aufweist.

Weitere Ausführungsformen der vorliegenden Erfindung sind Gegenstand der weiteren Unteransprüche und der nachfolgenden Beschreibung unter Bezugnahme auf die Figuren.

Gemäß einer bevorzugten Weiterbildung der Erfindung ist vorgesehen, dass der erste Datensatz von Sensordaten durch einen ersten Encoder des hierarchischen variational Autoencoders kodiert wird, wobei eine Bildauflösung des ersten Datensatzes um einen vorgegebenen Faktor, insbesondere 2⁴, reduziert wird. Somit kann in vorteilhafter Weise eine um den vorgegebenen Faktor dimensionsreduzierte Repräsentation des ersten Datensatzes erzeugt werden.

Gemäß einer weiteren bevorzugten Weiterbildung ist vorgesehen, dass der durch den ersten Encoder kodierte erste Datensatz von Sensordaten in die erste Hierarchieebene und die zweite Hierarchieebene aufgeteilt wird, wobei der erste Datensatz von Sensordaten in der ersten Hierarchieebene durch einen zweiten Encoder des hierarchischen variational Autoencoders kodiert wird, und wobei eine Bildauflösung des ersten Datensatzes um einen vorgegebenen Faktor, insbesondere 2², reduziert wird. In der ersten Hierarchieebene erfolgt somit in vorteilhafter Weise eine weitere Dimensionsreduzierung des ersten Datensatzes um den vorgegebenen Faktor.

Gemäß einer weiteren bevorzugten Weiterbildung ist vorgesehen, dass der durch den zweiten Encoder zu einem ersten Merkmalsvektor kodierte erste Datensatz von Sensordaten durch ein erstes autoregressives künstliches neuronales Netz, insbesondere ein künstliches neuronales Faltungsnetz, der ersten Hierarchieebene dem ersten Codebuch-Vektor zugeordnet wird, welcher einen geringsten Abstand zum ersten Merkmalsvektor aufweist.

Somit kann in vorteilhafter Weise eine bestmögliche Zuordnung des erzeugten Merkmalsvektors, welcher die numerisch parametrierbaren Eigenschaften des ersten Datensatzes in vektorieller Weise zusammenfasst, zum ersten Codebuch-Vektor ermöglicht werden.

Gemäß einer weiteren bevorzugten Weiterbildung ist vorgesehen, dass der erste Codebuch-Vektor durch einen ersten Decoder des hierarchischen variational Autoencoders dekodiert wird, wobei die Bildauflösung des ersten Codebuch-Vektors um einen vorgegebenen Faktor, insbesondere 2², erhöht wird. Somit kann in vorteilhafter Weise eine effiziente dimensionserhöhte Repräsentation des ersten Codebuch-Vektors ermöglicht werden.

Gemäß der Erfindung ist vorgesehen, dass der durch den ersten Decoder der ersten Hierarchieebene ausgegebene erste Datensatz mit dem durch den ersten Encoder des hierarchischen variational Autoencoders kodierten ersten Datensatz auf der zweiten Hierarchieebene zu dem resultierenden dritten Merkmalsvektor zusammengeführt wird.

Der erste Datensatz der ersten Hierarchieebene, welcher globale Merkmale des ursprünglichen ersten Datensatzes aufweist, konditioniert somit den ersten Datensatz der zweiten Hierarchieebene.

Gemäß einer weiteren bevorzugten Weiterbildung ist vorgesehen, dass der resultierende dritte Merkmalsvektor durch ein zweites autoregressives künstliches neuronales Netz, insbesondere ein künstliches neuronales Faltungsnetz, der zweiten Hierarchieebene dem zweiten Codebuch-Vektor zugeordnet wird, welcher einen geringsten Abstand zum resultierenden dritten Merkmalsvektor aufweist.

Somit kann in vorteilhafter Weise eine bestmögliche Zuordnung des dritten Merkmalsvektors zu dem zweiten Codebuch-Vektor ermöglicht werden.

Gemäß einer weiteren bevorzugten Weiterbildung ist vorgesehen, dass der zweite Datensatz von Sensordaten des Umfelderfassungssensors des Fahrzeugs auf der dritten Hierarchieebene durch einen dritten Encoder kodiert wird, wobei eine Bildauflösung des zweiten Datensatzes um einen vorgegebenen Faktor, insbesondere 2⁸, reduziert wird. Somit kann in vorteilhafter Weise eine um den vorgegebenen Faktor dimensionsreduzierte Repräsentation des zweiten Datensatzes erzeugt werden.

Gemäß einer weiteren bevorzugten Weiterbildung ist vorgesehen, dass der durch den dritten Encoder zu einem vierten Merkmalsvektor kodierte zweite Datensatz von Sensordaten durch ein drittes autoregressives künstliches neuronales Netz, insbesondere ein künstliches neuronales Faltungsnetz, der dritten Hierarchieebene einem dritten Codebuch-Vektor zugeordnet wird, welcher einen geringsten Abstand zum vierten Merkmalsvektor des zweiten Datensatzes aufweist.

Somit kann in vorteilhafter Weise eine bestmögliche Zuordnung des vierten Merkmalsvektors zum dritten Codebuch-Vektor ermöglicht werden.

Gemäß der Erfindung ist vorgesehen, dass der dritte Codebuch-Vektor durch einen zweiten Decoder des hierarchischen variational Autoencoders oder den externen variational Autoencoder dekodiert wird, wobei der durch den zweiten Decoder ausgegebene zweite Datensatz den durch den variational Autoencoder der ersten Hierarchieebene kodierten ersten Merkmalsvektor und den durch den variational Autoencoder der zweiten Hierarchieebene kodierten zweiten Merkmalsvektor konditioniert.

Durch die Konditionierung der ersten Hierarchieebene und der zweiten Hierarchieebene durch die Ausgabedaten der dritten Hierarchieebene kann in vorteilhafter Weise eine Konditionierung der ersten Hierarchieebene und der zweiten Hierarchieebene ermöglicht werden.

Damit kann eine Transformation des Datensatzes der ersten Hierarchieebene und der zweiten Hierarchieebene bzw. des zusammengeführten Datensatzes der ersten Hierarchieebene und der zweiten Hierarchieebene ermöglicht werden kann. Dies hat den vorteilhaften Effekt, dass somit eine Modellierung bzw. Erzeugung von synthetischen Sensordaten durchgeführt werden kann, welche Distanzinformationen sowie transformierte und dadurch verbesserte Intensitätsinformationen aufweisen.

Die Transformation und dadurch bedingte Verbesserung des ersten Datensatzes wird durch die Konditionierung mit dem zweiten Datensatz, insbesondere den real erfassten Sensordaten des zweiten Datensatzes ermöglicht.

Gemäß einer weiteren Weiterbildung ist vorgesehen, dass der durch den variational Autoencoder der ersten Hierarchieebene kodierte erste Merkmalsvektor und der durch den variational Autoencoder der zweiten Hierarchieebene kodierte zweite Merkmalsvektor mit einer Datensatz-Kennzeichnung konditioniert werden, wobei die Datensatz-Kennzeichnung bezeichnet, ob es sich bei den Sensordaten um synthetisch erzeugte oder real erfasste Sensordaten handelt.

Durch diese zusätzliche Konditionierung der Daten der ersten Hierarchieebene und der zweiten Hierarchieebene durch die Datensatz-Kennzeichnung kann in vorteilhafter Weise durch das autoregressive künstliche neuronale Netz der ersten und/oder zweiten Hierarchieebene eine verbesserte Modellierung der Zielfunktion bzw. der auszugebenden synthetischen Sensordaten des Umfelderfassungssensors ermöglicht werden.

Die hierin beschriebenen Merkmale des Verfahrens sind auf eine Vielzahl virtueller Umgebungen wie beispielsweise das Testen autonomer Kraftfahrzeuge, Luftfahrzeuge und/oder Raumfahrzeuge anwendbar.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: ein Ablaufdiagramm eines computerimplementierten Verfahrens zum Erzeugen synthetischer Sensordaten eines Umfelderfassungssensors eines Fahrzeugs;

- Fig. 2: ein detailliertes Ablauf- und Systemdiagramm des Verfahrens und Systems zum Erzeugen synthetischer Sensordaten des Umfelderfassungssensors des Fahrzeugs;

- Fig. 3: eine beispielhafte Matrix, welche zur Modellierung einer Zielfunktion verwendet wird;
- Fig. 4: eine nicht der vorliegenden Erfindung zugehörige Darstellung eines rezeptiven Bereichs eines herkömmlichen Modells, welches einen Blindfleck aufweist;
- Fig. 5: eine Darstellung eines rezeptiven Bereichs des Modells bzw. des künstlichen neuronalen Netzes;
- Fig. 6: ein Ablaufdiagramm zum Trainieren einer ersten Hierarchieebene eines hierarchischen variational Autoencoders;

- Fig. 7: ein Ablaufdiagramm eines Verfahrens zum Trainieren einer zweiten Hierarchieebene des hierarchischen variational Autoencoders; und
- Fig. 8: ein Ablaufdiagramm des Verfahrens zum Bereitstellen eines trainierten Algorithmus maschinellen Lernens zum Erzeugen synthetischer Sensordaten des Umfelderfassungssensors.

Sofern nicht anders angegeben, bezeichnen gleiche Bezugszeichen gleiche Elemente der Zeichnungen.

### Ausführliche Beschreibung der Ausführungsformen

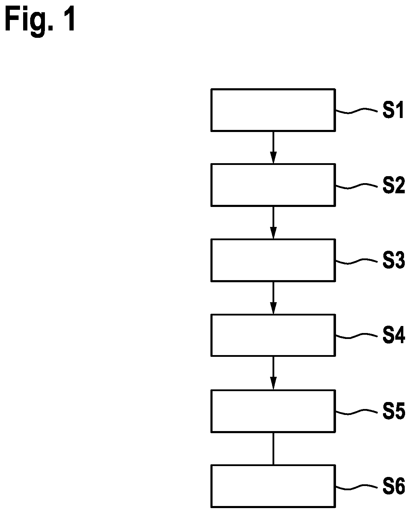

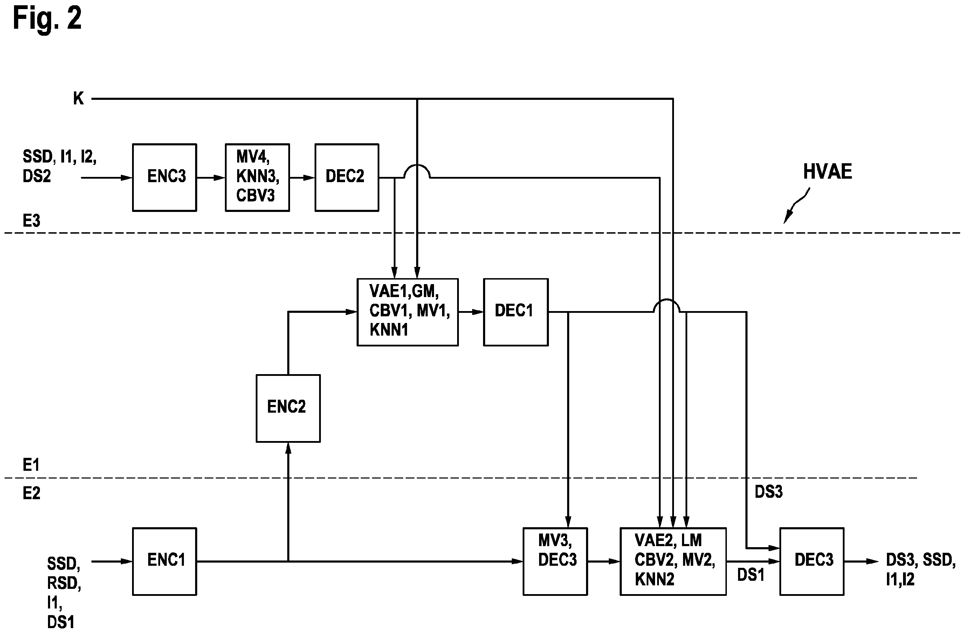

Fig. 1 zeigt ein Ablaufdiagramm und Fig. 2 zeigt ein detailliertes Ablauf- und Systemdiagramm des Verfahrens und Systems zum Erzeugen synthetischer Sensordaten des Umfelderfassungssensors des Fahrzeugs.

In der bevorzugten Ausführungsform der Erfindung handelt es sich bei den synthetischen Sensordaten SSD des Umfelderfassungssensors um Sensordaten eines LiDAR-Sensors eines Fahrzeugs.

Alternativ kann es sich bei dem Umfelderfassungssensor beispielsweise um einen Kamerasensor oder einen Radarsensor handeln.

Im Falle der Verwendung eines Kamerasensors können die in Videobilddaten enthaltenen Distanzinformationen beispielsweise geometrisch berechnet werden. Die Intensitätsinformationen können beispielsweise über Graustufenwerte oder RGB-Farbkanäle codiert sein.

Im Falle der Verwendung eines Radarsensors können die Intensitätsinformationen beispielsweise über eine Bildhelligkeit codiert sein, wobei hellere Pixelwerte eine höhere Objektreflexion und daraus resultierend eine höhere Bildintensität repräsentieren, wohingegen dunklere Pixelwerte eine geringere Objektreflexion und somit eine niedrigere Bildintensität repräsentieren.

Die nachfolgende Beschreibung bezieht sich sowohl auf Fig. 1 und Fig. 2. Das Verfahren und System umfassen ein Bereitstellen S1 eines hierarchischen variational Autoencoders HVAE, welcher eine erste Hierarchieebene E1, eine zweite Hierarchieebene E2 und eine dritte Hierarchieebene E3 aufweist.

Alternativ kann die dritte Hierarchieebene E3 beispielsweise nicht Teil des hierarchischen variational Autoencoders HVAE sein, sondern eine externe Hierarchieebene E3 bilden, wobei der hierarchische variational Autoencoder HVAE in diesem Fall dazu eingerichtet ist, mit der externen dritten Hierarchieebene E3 eines externen variational Autoencoders zu kommunizieren.

Ein variational Autoencoder weist ein künstliches neuronales Netz auf, welches verwendet wird, um effiziente Datenkodierungen unbeaufsichtigt zu lernen. Das Ziel eines variational Autoencoders ist es, eine Repräsentation bzw. Kodierung für einen Datensatz zu lernen, typischerweise zur Reduktion der Dimensionalität.

Im Gegensatz zu klassischen Autoencodern sind variational Autoencoder generative Modelle, wobei sich die Assoziation mit einem klassischen Autoencoder hauptsächlich aus der architektonischen Verwandtschaft, d.h. einem Encoder und einem Decoder, ergibt.

Ihre mathematische Formulierung unterscheidet sich jedoch erheblich. Variational Autoencoder sind gewichtete probabilistische grafische Modelle, deren Zielfunktion durch ein neuronales Netz approximiert wird. Der Encoder erzeugt hierbei einen Merkmalsvektor, welcher numerisch parametrierbare Eigenschaften eines Musters in vektorieller Weise zusammenfasst.

Verschiedene, für das Muster charakteristische Merkmale bilden die verschiedenen Dimensionen dieses Vektors. Die Gesamtheit der möglichen Merkmalsvektoren wird hierbei als Merkmalsraum bezeichnet. Merkmalsvektoren erleichtern eine automatische Klassifikation, da sie die zu klassifizierenden Eigenschaften stark reduzieren. Statt eines kompletten Bildes muss z.B. nur ein Vektor aus einer vorgegebenen Anzahl von Zahlen betrachtet werden. Der durch den Encoder erzeugte Merkmalsvektor wird anschließend durch ein künstliches neuronales Netz einem vorab erstellten Codebuch-Vektor zugeordnet.

Das Verfahren umfasst ferner ein Empfangen S2 eines Distanzinformationen I1 aufweisenden ersten Datensatzes DS1 von Sensordaten, insbesondere synthetisch erzeugte und real erfasste Sensordaten SSD, RSD, des Umfelderfassungssensors des Fahrzeugs durch einen variational Autoencoder VAE1 der ersten Hierarchieebene E1.

Alternativ können beispielsweise lediglich synthetische oder real erfasste Sensordaten SSD, RSD verwendet werden.

Der variational Autoencoder VAE1 der ersten Hierarchieebene E1 ordnet globale Merkmale GM des ersten Datensatzes DS1 von Sensordaten einem ersten CodebuchVektor CBV1 zu.

Das Verfahren umfasst ferner ein Empfangen S3 des ersten Datensatzes DS1 von Sensordaten des Umfelderfassungssensors des Fahrzeugs durch einen variational Autoencoder VAE2 der zweiten Hierarchieebene E2. Der variational Autoencoder VAE2 der zweiten Hierarchieebene E2 ordnet lokale Merkmale LM des ersten Datensatzes DS1 von Sensordaten einem zweiten CodebuchVektor CBV2 zu.

Globale Merkmale GM des ersten Datensatzes werden als Grobmerkmale verstanden. Da es sich bei der vorliegenden Ausführungsform um synthetische Sensordaten eines Umfelderfassungssensors eines Fahrzeugs handelt, versteht man unter globalen Merkmalen bzw. Grobmerkmalen des ersten Datensatzes DS1 somit die in den grafischen Daten bzw. der LiDAR-Punktwolke enthaltenen Objekte, die als solche erkannt werden.

Hierbei kann es sich beispielsweise um Gebäude, stehende oder sich bewegende Fahrzeuge, Vegetation, Verkehrszeichen, Personen oder ähnliches handeln.

Unter lokalen Merkmalen LM sind Feinmerkmale von in den synthetischen Sensordaten des Umfelderfassungssensors, insbesondere des LiDAR-Sensors, des Fahrzeugs enthaltenen Objekten zu verstehen. Feinmerkmale können beispielsweise eine Unterscheidung einer Art der Objekte ermöglichen. Dies bedeutet beispielsweise eine Unterscheidung zwischen der Art von Fußgängern, beispielsweise eine Klassifizierung von Alter und/oder Geschlecht, die Feststellung einer Fahrzeugart wie beispielsweise ein Personenkraftwagen, ein Zweirad oder ein Nutzfahrzeug oder ferner eine Vegetationsart.

Das Verfahren umfasst ferner ein Konditionieren S4 eines durch den variational Autoencoder VAE1 der ersten Hierarchieebene E1 kodierten ersten Merkmalsvektors MV1 und eines durch den variational Autoencoder VAE2 der zweiten Hierarchieebene E2 kodierten zweiten Merkmalsvektors MV2 mit einem Distanz- und Intensitätsinformationen I1, I2 aufweisenden zweiten Datensatz DS2 von Sensordaten des Umfelderfassungssensors des Fahrzeugs.

Anschließend erfolgt ein Zusammenführen S5 des konditionierten ersten Merkmalsvektors MV1 und des konditionierten zweiten Merkmalsvektors MV2 zu einem resultierenden dritten Merkmalsvektor MV3 sowie ein Dekodieren S6 des resultierenden dritten Merkmalsvektors MV3 zum Erzeugen eines überlagerte Distanz- und Intensitätsinformationen I1, I2 aufweisenden dritten Datensatzes DS3 synthetischer Sensordaten SSD des Umfelderfassungssensors des Fahrzeugs.

Mit Bezug auf Fig. 2 wird nun die zeitliche Abfolge des Verfahrens zum Erzeugen von überlagerte Distanz- und Intensitätsinformationen I1, I2 aufweisenden synthetischen Sensordaten SSD des Umfelderfassungssensors des Fahrzeugs beschrieben. Der erste Datensatz DS1 von Sensordaten wird zunächst durch einen ersten Encoder ENC1 des hierarchischen variational Autoencoders HVAE kodiert. Eine Bildauflösung des ersten Datensatzes DS1 wird dabei um einen vorgegebenen Faktor, insbesondere 2⁴, reduziert.

Der durch den ersten Encoder ENC1 kodierte erste Datensatz DS1 von Sensordaten wird anschließend in die erste Hierarchieebene E1 und die zweite Hierarchieebene E2 aufgeteilt.

Der erste Datensatz DS1 von Sensordaten wird in der ersten Hierarchieebene E1 durch einen zweiten Encoder ENC2 des hierarchischen variational Autoencoders HVAE kodiert. Eine Bildauflösung des ersten Datensatzes DS1 wird dabei um einen vorgegebenen Faktor, insbesondere 2², weiter reduziert.

Der durch den zweiten Encoder ENC2 zu einem ersten Merkmalsvektor MV1 kodierte erste Datensatz DS1 von Sensordaten wird anschließend durch ein erstes autoregressives künstliches neuronales Netz KNN1, insbesondere ein künstliches neuronales Faltungsnetz, der ersten Hierarchieebene E1 dem ersten Codebuch-Vektor CBV1 zugeordnet, welcher einen geringsten Abstand zum ersten Merkmalsvektor MV1 aufweist.

Der erste Codebuch-Vektor CBV1 wird anschließend durch einen ersten Decoder DEC1 des hierarchischen variational Autoencoders HVAE dekodiert. Die Bildauflösung des ersten Codebuch-Vektors CBV1 wird dabei um einen vorgegebenen Faktor, insbesondere 2², erhöht.

Der durch den ersten Decoder DEC1 der ersten Hierarchieebene E1 ausgegebene erste Datensatz DS1 wird mit dem durch den ersten Encoder ENC1 des hierarchischen variational Autoencoders HVAE kodierten ersten Datensatz DS1 auf der zweiten Hierarchieebene E2 zu dem resultierenden dritten Merkmalsvektor MV3 zusammengeführt.

Der resultierende dritte Merkmalsvektor MV3 wird durch ein zweites autoregressives künstliches neuronales Netz KNN2, insbesondere ein künstliches neuronales Faltungsnetz, der zweiten Hierarchieebene E2 dem zweiten Codebuch-Vektor CBV2 zugeordnet, welcher einen geringsten Abstand zum resultierenden dritten Merkmalsvektor MV3 aufweist.

Der den geringsten Abstand zum resultierenden dritten Merkmalsvektor MV3 aufweisende zweite Codebuch-Vektor CBV2 weist dabei ein gegenüber anderen Codebuch-Vektoren des Codebuchs bzw. einer Tabelle größtes Ähnlichkeitsmaß auf. Häufig benutzte Abstandsmaße sind beispielsweise der euklidische Abstand, der gewichtete euklidische Abstand und/oder der Mahalanobis-Abstand.

Der zweite Datensatz DS2 von Sensordaten des Umfelderfassungssensors des Fahrzeugs wird ferner auf der dritten Hierarchieebene E3 durch einen dritten Encoder ENC3 kodiert. Eine Bildauflösung des zweiten Datensatzes DS2 wird dabei um einen vorgegebenen Faktor, insbesondere 2⁸, reduziert.

Der durch den dritten Encoder ENC3 zu einem vierten Merkmalsvektor MV4 kodierte zweite Datensatz DS2 von Sensordaten wird durch ein drittes autoregressives künstliches neuronales Netz KNN3, insbesondere ein künstliches neuronales Faltungsnetz, der dritten Hierarchieebene E3 einem dritten Codebuch-Vektor CBV3 zugeordnet, welcher einen geringsten Abstand zum vierten Merkmalsvektor MV4 des zweiten Datensatzes DS2 aufweist.

Der dritte Codebuch-Vektor CBV3 wird anschließend durch einen zweiten Decoder DEC2 des hierarchischen variational Autoencoders HVAE oder den externen variational Autoencoder dekodiert. Der durch den zweiten Decoder DEC2 ausgegebene zweite Datensatz DS2 konditioniert den durch den variational Autoencoder VAE1 der ersten Hierarchieebene E1 kodierten ersten Merkmalsvektor MV1 und den durch den variational Autoencoder VAE2 der zweiten Hierarchieebene E2 kodierten zweiten Merkmalsvektor MV2.

Der durch den variational Autoencoder VAE1 der ersten Hierarchieebene E1 kodierte erste Merkmalsvektor MV1 und der durch den variational Autoencoder VAE2 der zweiten Hierarchieebene E2 kodierte zweite Merkmalsvektor MV2 werden ferner mit einer Datensatz-Kennzeichnung K konditioniert. Die Datensatz-Kennzeichnung K bezeichnet, ob es sich bei den Sensordaten um synthetisch erzeugte oder real erfasste Sensordaten SSD, RSD handelt.

Der durch den zweiten variational Autoencoder VAE2 der zweiten Hierarchieebene E2 kodierte zweite Merkmalsvektor MV2 wird anschließend nochmals mit dem dritten Datensatz DS1 der ersten Hierarchieebene E1 zusammengeführt.

Der daraus resultierende Vektor wird durch einen dritten Decoder DEC3 dekodiert. Hierdurch werden die überlagerte Distanz- und Intensitätsinformationen I1, I2 aufweisenden synthetischen Sensordaten SSD des Umfelderfassungssensors, insbesondere des LiDAR-Sensors, des Fahrzeugs erzeugt.

Das Erzeugen synthetischer Sensordaten des Umfelderfassungssensors des Fahrzeugs umfasst somit eine Transformation der durch den hierarchischen variational Autoencoder empfangenen Eingangsdaten, d.h. des ersten Datensatzes DS1, durch die Konditionierung mit dem zweiten Datensatz DS2 zum Erzeugen des dritten Datensatzes DS3, welcher zusätzlich zu den im ersten Datensatz DS1 enthaltenen Distanzinformationen I1 verbesserte Intensitätsinformationen I2 aufweist.

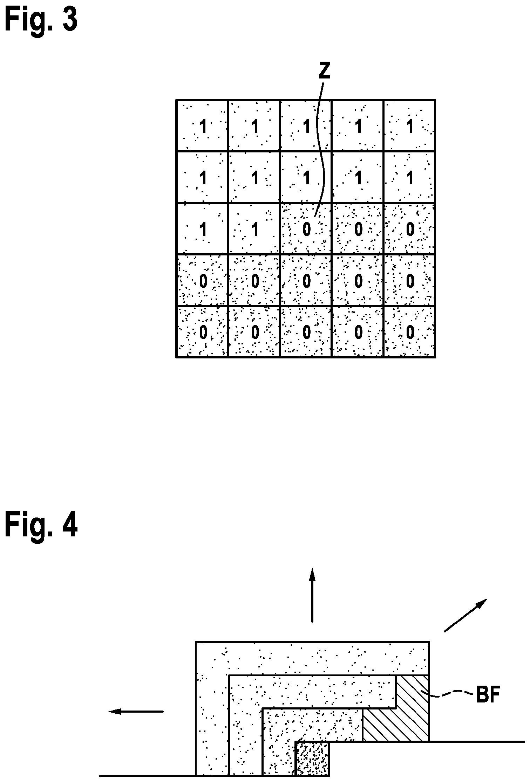

Fig. 3 zeigt eine Beispielmatrix des autoregressiven künstlichen neuronalen Netzes KNN1, KNN2, insbesondere des künstlichen neuronalen Faltungsnetzes, der ersten Hierarchieebene E1 und der zweiten Hierarchieebene E2. Das künstliche neuronale Faltungsnetz verwendet die in Fig. 3 gezeigte maskierte Faltung. Den Pixeln Z wird dabei eine Reihenfolge auferlegt, nämlich zahlenweise von links nach rechts oben angefangen und unten endend. Die Wahrscheinlichkeit eines nächsten Pixels hängt hierbei von dem bzw. den zuvor erzeugten Pixeln ab. Das Modell kann hierbei keine Pixel unterhalb sowie rechts des aktuellen Pixels lesen, um seine Vorhersagen zu treffen. Herkömmliche künstliche neuronale Faltungsnetze, welche zur Pixelgenerierung verwendet werden, haben in der Regel, wie in Fig. 4 zu sehen, einen blinden Fleck BF im rezeptiven Feld, der nicht für Vorhersagen verwendet werden kann.

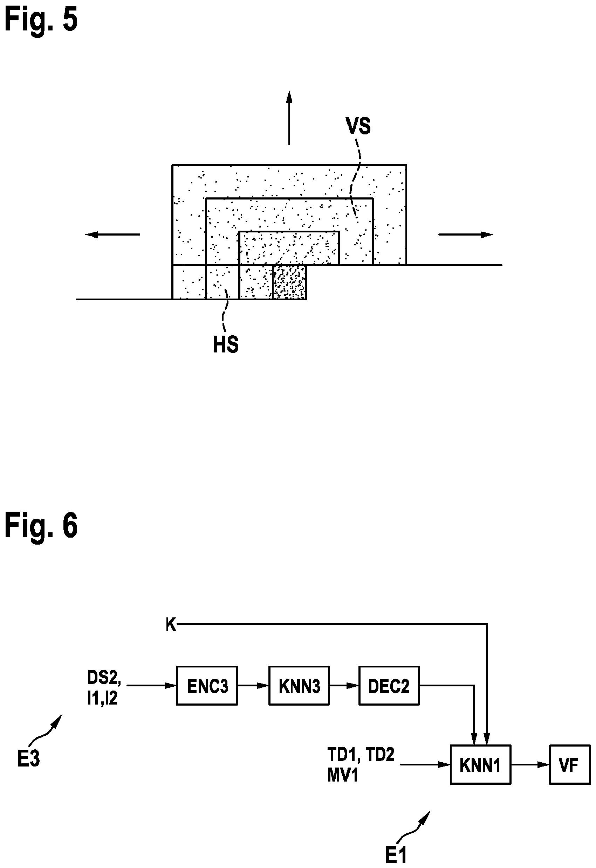

Gemäß Fig. 5 werden zwei Faltungsstapel, ein horizontaler Stapel und ein vertikaler Stapel, verwendet, welche es erlauben, den gesamten rezeptiven Bereich bzw. das rezeptive Feld zu erfassen.

Durch die Kombination der beiden Faltungsnetzstapel ist es somit möglich, den blinden Fleck im rezeptiven Bereich zu entfernen. Der horizontale Stapel konditioniert dabei die aktuelle Reihe bis zum aktuellen Pixel. Der vertikale Stapel konditioniert alle darüber liegenden Reihen. Der vertikale Stapel, der keine Maskierung aufweist, erlaubt es dem rezeptiven Bereich, ohne blinden Fleck rechteckig zu wachsen, und die Ausgänge der beiden Stapel nach jeder Schicht zu kombinieren.

Jedes Mal, wenn ein Pixel vorhergesagt wird, wird es in das neuronale Faltungsnetz zurückgeführt, um das nächste Pixel vorherzusagen. Diese Sequenzialität ist für die Erzeugung von Bildern hoher Qualität unerlässlich, da sie es ermöglicht, dass jedes Pixel in einer hochgradig nicht linearen und multimodalen Weise von den vorhergehenden Pixeln abhängt.

Jede Schicht des horizontalen Stapels nimmt als Eingabe die Ausgabe der vorherigen Schicht sowie die des vorherigen Stapels.

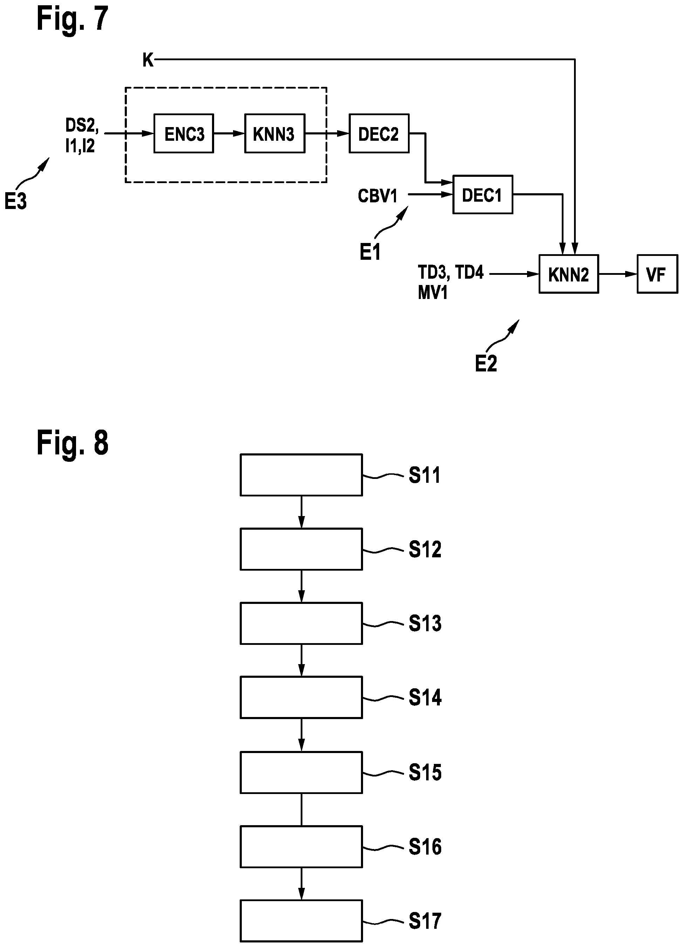

Fig. 6 zeigt ein Ablaufdiagramm zum Trainieren einer ersten Hierarchieebene eines hierarchischen variational Autoencoders gemäß der bevorzugten Ausführungsform der Erfindung. Fig. 7 zeigt ein Ablaufdiagramm eines Verfahrens zum Trainieren einer zweiten Hierarchieebene des hierarchischen variational Autoencoders gemäß der bevorzugten Ausführungsform der Erfindung und Fig. 8 ein Ablaufdiagramm des Verfahrens zum Bereitstellen eines trainierten Algorithmus maschinellen Lernens zum Erzeugen synthetischer Sensordaten des Umfelderfassungssensors.

Nachfolgend wird das Verfahren zum Training der ersten Hierarchieebene E1 und der zweiten Hierarchieebene E2 des hierarchischen variational Autoencoders HVAE beschrieben.

Das Verfahren umfasst ein Bereitstellen S11 eines hierarchischen variational Autoencoders HVAE, welcher die erste Hierarchieebene E1 und die zweite Hierarchieebene E2 aufweist. Die dritte Hierarchieebene E3 ist im vorliegenden Ausführungsbeispiel ebenfalls Teil des hierarchischen variational Autoencoders HVAE3.

Alternativ kann die dritte Hierarchieebene E3 beispielsweise nicht Teil des hierarchischen variational Autoencoders HVAE sein.

Das Verfahren umfasst ferner ein Empfangen S12, S13 von Eingabe-Trainingsdaten TD1 und Ausgabe-Trainingsdaten TD2 eines ersten autoregressiven künstlichen neuronalen Netzes KNN1, insbesondere eines künstlichen neuronalen Faltungsnetzes, der ersten Hierarchieebene E1.

Das Verfahren umfasst ferner ein Trainieren S14 des ersten autoregressiven künstlichen neuronalen Netzes KNN1, insbesondere des künstlichen neuronalen Faltungsnetzes, der ersten Hierarchieebene E1 zum Zuordnen von globalen Merkmalen GM der Eingabe-Trainingsdaten TD1 zu einem ersten Codebuch-Vektor CBV1.

Codebuch-Vektoren werden durch das Verfahren der Vektorquantisierung erzeugt. Die Vektorquantisierung besteht aus zwei Schritten. Im ersten Schritt, dem Training, wird eine Tabelle bzw. Codebuch mit häufig vorkommenden Merkmalsvektoren erstellt. Im zweiten Schritt wird für weitere Vektoren jeweils der Codebuchvektor mit dem geringsten Abstand bestimmt.

Zur Datenübertragung wird nur der Index des Codebuchvektors benötigt, der auch ein Vektor sein kann, wenn das Codebuch mehrdimensional ist. Der korrespondierende Decoder muss über das gleiche Codebuch verfügen und kann dann aus dem Index eine Approximation des ursprünglichen Vektors erzeugen.

Darüber hinaus umfasst das Verfahren ein Empfangen S15, S16 von Eingabe-Trainingsdaten TD3 und Ausgabe-Trainingsdaten TD4 eines zweiten autoregressiven künstlichen neuronalen Netzes KNN2, insbesondere eines künstlichen neuronalen Faltungsnetzes, der zweiten Hierarchieebene E2.

Ferner umfasst das Verfahren ein Trainieren S17 des zweiten autoregressiven künstlichen neuronalen Netzes KNN2, insbesondere des künstlichen neuronalen Faltungsnetzes, der zweiten Hierarchieebene E2 zum Zuordnen von lokalen Merkmalen LM der Eingabe-Trainingsdaten TD3 zu einem zweiten Codebuch-Vektor CBV2. Das zweite autoregressive künstliche neuronale Netz KNN2 der zweiten Hierarchieebene E2 wird dabei durch das autoregressive künstliche neuronale Netz KNN1 der ersten Hierarchieebene E1 konditioniert.

Obwohl hierin spezifische Ausführungsformen illustriert und beschrieben wurden, ist es dem Fachmann verständlich, dass eine Vielzahl von alternativen und/oder äquivalenten Implementierungen existieren.

Vielmehr liefert die vorstehend genannte Zusammenfassung und ausführliche Beschreibung dem Fachmann eine bequeme Anleitung zur Implementierung zumindest einer beispielhaften Ausführungsform, wobei verständlich ist, dass verschiedene Änderungen im Funktionsumfang und der Anordnung der Elemente vorgenommen werden können, ohne vom Umfang der beigefügten Ansprüche und ihrer rechtlichen Äquivalente abzuweichen.

Im Allgemeinen beabsichtigt diese Anmeldung, Änderungen bzw. Anpassungen oder Variationen der hierin dargestellten Ausführungsformen abzudecken.

## Patentansprüche

1. Computerimplementiertes Verfahren zum Erzeugen von überlagerte Distanz- und Intensitätsinformationen (I1, I2) aufweisenden synthetischen Sensordaten (SSD) eines Umfelderfassungssensors, insbesondere eines LiDAR-Sensors, eines Fahrzeugs, mit den Schritten:
Bereitstellen (S1) eines hierarchischen variational Autoencoders (HVAE), welcher eine erste Hierarchieebene (E1), eine zweite Hierarchieebene (E2) und eine dritte Hierarchieebene (E3) aufweist oder dazu eingerichtet ist, mit der dritten Hierarchieebene (E3) eines externen variational Autoencoders zu kommunizieren;
Empfangen (S2) eines Distanzinformationen (I1) aufweisenden ersten Datensatzes (DS1) von Sensordaten, insbesondere synthetisch erzeugter und/oder real erfasster Sensordaten (SSD, RSD), des Umfelderfassungssensors des Fahrzeugs durch einen variational Autoencoder (VAE1) der ersten Hierarchieebene (E1), welcher globale Merkmale (GM) des ersten Datensatzes (DS1) von Sensordaten einem ersten CodebuchVektor (CBV1) zuordnet, wobei die globalen Merkmale (GM) in den Sensordaten enthaltenen Objekte, die als solche erkannt werden darstellen;
Empfangen (S3) des ersten Datensatzes (DS1) von Sensordaten des Umfelderfassungssensors des Fahrzeugs durch einen variational Autoencoder (VAE2) der zweiten Hierarchieebene (E2), welcher lokale Merkmale (LM) des ersten Datensatzes (DS1) von Sensordaten einem zweiten Codebuch-Vektor (CBV2) zuordnet, wobei die lokalen Merkmale (LM) Feinmerkmale der in den Sensordaten enthaltenen Objekten darstellen;
Konditionieren (S4) eines durch den variational Autoencoder (VAE1) der ersten Hierarchieebene (E1) kodierten ersten Merkmalsvektors (MV1) und eines durch den variational Autoencoder (VAE2) der zweiten Hierarchieebene (E2) kodierten zweiten Merkmalsvektors (MV2) mit einem Distanz- und Intensitätsinformationen (I1, I2) aufweisenden zweiten Datensatz (DS2) von Sensordaten des Umfelderfassungssensors des Fahrzeugs;
Zusammenführen (S5) des konditionierten ersten Merkmalsvektors (MV1) und des konditionierten zweiten Merkmalsvektors (MV2) zu einem resultierenden dritten Merkmalsvektor (MV3); und
Dekodieren (S6) des resultierenden dritten Merkmalsvektors (MV3), mittels des Decoders der dritten Hierarchieebene (E3), zum Erzeugen eines überlagerte Distanz- und Intensitätsinformationen (I1, I2) aufweisenden dritten Datensatzes (DS3) synthetischer Sensordaten (SSD) des Umfelderfassungssensors des Fahrzeugs.

2. Computerimplementiertes Verfahren nach Anspruch 1, **dadurch gekennzeichnet, dass** der erste Datensatz (DS1) von Sensordaten durch einen ersten Encoder (ENC1) des hierarchischen variational Autoencoders (HVAE) kodiert wird, wobei eine Bildauflösung des ersten Datensatzes (DS1) um einen vorgegebenen Faktor, insbesondere 2⁴, reduziert wird.

3. Computerimplementiertes Verfahren nach Anspruch 2, **dadurch gekennzeichnet, dass** der durch den ersten Encoder (ENC1) kodierte erste Datensatz (DS1) von Sensordaten in die erste Hierarchieebene (E1) und die zweite Hierarchieebene (E2) aufgeteilt wird, wobei der erste Datensatz (DS1) von Sensordaten in der ersten Hierarchieebene (E1) durch einen zweiten Encoder (ENC2) des hierarchischen variational Autoencoders (HVAE) kodiert wird, wobei eine Bildauflösung des ersten Datensatzes (DS1) um einen vorgegebenen Faktor, insbesondere 2², reduziert wird.

4. Computerimplementiertes Verfahren nach Anspruch 3, **dadurch gekennzeichnet, dass** der durch den zweiten Encoder (ENC2) zu einem ersten Merkmalsvektor (MV1) kodierte erste Datensatz (DS1) von Sensordaten durch ein erstes autoregressives künstliches neuronales Netz (KNN1), insbesondere ein künstliches neuronales Faltungsnetz, der ersten Hierarchieebene (E1) dem ersten Codebuch-Vektor (CBV1) zugeordnet wird, welcher einen geringsten Abstand zum ersten Merkmalsvektor (MV1) aufweist.

5. Computerimplementiertes Verfahren nach Anspruch 4, **dadurch gekennzeichnet, dass** der erste Codebuch-Vektor (CBV1) durch einen ersten Decoder (DEC1) des hierarchischen variational Autoencoders (HVAE) decodiert wird, wobei die Bildauflösung des ersten Codebuch-Vektors (CBV1) um einen vorgegebenen Faktor, insbesondere 2², erhöht wird.

6. Computerimplementiertes Verfahren nach Anspruch 5, **dadurch gekennzeichnet, dass** der durch den ersten Decoder (DEC1) der ersten Hierarchieebene (E1) ausgegebene erste Datensatz (DS1) mit dem durch den ersten Encoder (ENC1) des hierarchischen variational Autoencoders (HVAE) kodierten ersten Datensatz (DS1) auf der zweiten Hierarchieebene (E2) zu dem resultierenden dritten Merkmalsvektor (MV3) zusammengeführt wird.

7. Computerimplementiertes Verfahren nach Anspruch 6, **dadurch gekennzeichnet, dass** der resultierende dritte Merkmalsvektor (MV3) durch ein zweites autoregressives künstliches neuronales Netz (KNN2), insbesondere ein künstliches neuronales Faltungsnetz, der zweiten Hierarchieebene (E2) dem zweiten Codebuch-Vektor (CBV2) zugeordnet wird, welcher einen geringsten Abstand zum resultierenden dritten Merkmalsvektor (MV3) aufweist.

8. Computerimplementiertes Verfahren nach einem der vorhergehenden Ansprüche, **dadurch gekennzeichnet, dass** der zweite Datensatz (DS2) von Sensordaten des Umfelderfassungssensors des Fahrzeugs auf der dritten Hierarchieebene (E3) durch einen dritten Encoder (ENC3) kodiert wird, wobei eine Bildauflösung des zweiten Datensatzes (DS2) um einen vorgegebenen Faktor, insbesondere 2⁸, reduziert wird.

9. Computerimplementiertes Verfahren nach Anspruch 8, **dadurch gekennzeichnet, dass** der durch den dritten Encoder (ENC3) zu einem vierten Merkmalsvektor (MV4) kodierte zweite Datensatz (DS2) von Sensordaten durch ein drittes autoregressives künstliches neuronales Netz (KNN3), insbesondere ein künstliches neuronales Faltungsnetz, der dritten Hierarchieebene (E3) einem dritten Codebuch-Vektor (CBV3) zugeordnet wird, welcher einen geringsten Abstand zum vierten Merkmalsvektor (MV4) des zweiten Datensatzes (DS2) aufweist.

10. Computerimplementiertes Verfahren nach Anspruch 9, **dadurch gekennzeichnet, dass** der dritte Codebuch-Vektor (CBV3) durch einen zweiten Decoder (DEC2) des hierarchischen variational Autoencoders (HVAE) oder den externen variational Autoencoder decodiert wird, wobei der durch den zweiten Decoder (DEC2) ausgegebene zweite Datensatz (DS2) den durch den variational Autoencoder (VAE1) der ersten Hierarchieebene (E1) kodierten ersten Merkmalsvektor (MV1) und den durch den variational Autoencoder (VAE2) der zweiten Hierarchieebene (E2) kodierten zweiten Merkmalsvektor (MV2) konditioniert.

11. Computerimplementiertes Verfahren nach einem der vorhergehenden Ansprüche, **dadurch gekennzeichnet, dass** der durch den variational Autoencoder (VAE1) der ersten Hierarchieebene (E1) kodierte erste Merkmalsvektor (MV1) und der durch den variational Autoencoder (VAE2) der zweiten Hierarchieebene (E2) kodierte zweite Merkmalsvektor (MV2) mit einer Datensatz-Kennzeichnung (K) konditioniert werden, wobei die Datensatz-Kennzeichnung (K) bezeichnet, ob es sich bei den Sensordaten um synthetisch erzeugte oder real erfasste Sensordaten (SSD, RSD) handelt.

12. System (1) zum Erzeugen von überlagerte Distanz- und Intensitätsinformationen (I1, I2) aufweisenden synthetischen Sensordaten (SSD) eines Umfelderfassungssensors, insbesondere eines LiDAR-Sensors, eines Fahrzeugs, das System (1) umfassend einen Computer konfiguriert zur Implementierung eines hierarchischen variational Autoencoders (HVAE), welcher eine erste Hierarchieebene (E1), eine zweite Hierarchieebene (E2) und eine dritte Hierarchieebene (E3) aufweist oder dazu eingerichtet ist, mit der dritten Hierarchieebene (E3) eines externen variational Autoencoders zu kommunizieren, wobei der hierarchische variational Autoencoder (HVAE) dazu eingerichtet ist, einen Distanzinformationen (I1) aufweisenden ersten Datensatzes (DS1) von Sensordaten, insbesondere synthetisch erzeugter und/oder real erfasster Sensordaten (SSD, RSD), des Umfelderfassungssensors des Fahrzeugs durch einen variational Autoencoder (VAE1) der ersten Hierarchieebene (E1), welcher globale Merkmale (GM) des ersten Datensatzes (DS1) von Sensordaten einem ersten Codebuch-Vektor (CBV1) zuordnet, zu empfangen, wobei die globalen Merkmale (GM) in den Sensordaten enthaltenen Objekte, die als solche erkannt werden darstellen, wobei der hierarchische variational Autoencoder (HVAE) dazu eingerichtet ist, den ersten Datensatz (DS1) von Sensordaten des Umfelderfassungssensors des Fahrzeugs durch einen variational Autoencoder (VAE2) der zweiten Hierarchieebene (E2), welcher lokale Merkmale (LM) des ersten Datensatzes (DS1) von Sensordaten einem zweiten Codebuch-Vektor (CBV2) zuordnet, zu empfangen, wobei die lokalen Merkmale (LM) Feinmerkmale der in den Sensordaten enthaltenen Objekten darstellen, wobei der hierarchische variational Autoencoder (HVAE) dazu eingerichtet ist, einen durch den variational Autoencoder (VAE1) der ersten Hierarchieebene (E1) kodierten ersten Merkmalsvektor (MV1) und einen durch den variational Autoencoder (VAE2) der zweiten Hierarchieebene (E2) kodierten zweiten Merkmalsvektor (MV2) mit einem Distanz- und Intensitätsinformationen (I1, I2) aufweisenden zweiten Datensatz (DS2) von Sensordaten des Umfelderfassungssensors des Fahrzeugs zu konditionieren, wobei der hierarchische variational Autoencoder (HVAE) dazu eingerichtet ist, den konditionierten ersten Merkmalsvektor (MV1) und den konditionierten zweiten Merkmalsvektor (MV2) zu einem resultierenden dritten Merkmalsvektor (MV3) zusammenzuführen, und wobei der hierarchische variational Autoencoder (HVAE) dazu eingerichtet ist, mittels der dritte Hierarchieebene (E3), den resultierenden dritten Merkmalsvektor (MV3) zum Erzeugen eines überlagerte Distanz- und Intensitätsinformationen (I1, I2) aufweisenden dritten Datensatzes (DS3) synthetischer Sensordaten (SSD) des Umfelderfassungssensors des Fahrzeugs zu dekodieren.

13. Computerprogramm mit Programmcode, um das Verfahren nach einem der Ansprüche 1 bis 11 durchzuführen, wenn das Computerprogramm auf einem Computer ausgeführt wird.

14. Computerlesbarer Datenträger mit Programmcode eines Computerprogramms, um das Verfahren nach einem der Ansprüche 1 bis 11 durchzuführen, wenn das Computerprogramm auf einem Computer ausgeführt wird.

## Claims

1. A computer-implemented method for generating synthetic sensor data (SSD) having superimposed distance and intensity information (11, 12) from an environment detection sensor, in particular a LiDAR sensor, of a vehicle, comprising the steps:
providing (S1) a hierarchical variational autoencoder (HVAE), which has a first hierarchy level (E1), a second hierarchy level (E2) and a third hierarchy level (E3) or is configured to communicate with the third hierarchy level (E3) of an external variational autoencoder;
receiving (S2) a first data set (DS1), having distance information (11), of sensor data, in particular synthetically generated and/or actually detected sensor data (SSD, RSD), of the environment detection sensor of the vehicle by a variational autoencoder (VAE1) of the first hierarchical level (E1), which associates global features (GM) of the first data set (DS1) of sensor data with a first codebook vector (CBV1), where the global features (GM) represent objects contained in the sensor data that are recognized as such;
receiving (S 3) the first data set (DS 1) sensor data of the environment detection sensor of the vehicle by a variational autoencoder (VAE 2) of the second hierarchical level (E 2) which associates local features (LM) of the first data set (DS 1) of sensor data with a second codebook vector (CBV 2), where the local features (LM) represent fine features of the objects contained in the sensor data;
conditioning (S4) a first feature vector (MV1) encoded by the variational autoencoder (VAE1) of the first hierarchical level (E1) and a second feature vector (MV2) encoded by the variational autoencoder (VAE2) of the second hierarchical level (E2) with a second dataset (DS2) comprising distance and intensity information (I1, 12) of sensor data of the environment detection sensor of the vehicle;
merging (S5) the conditioned first feature vector (MV1) and the conditioned second feature vector (MV2) into a resulting third feature vector (MV3); and
Decoding (S 6) the resulting third feature vector (MV 3) to generate a third data set (DS 3) of synthetic sensor data (SSD) of the environment detection sensor of the vehicle having superimposed distance and intensity information (11, I 2).

2. Computer-implemented method according to claim 1, **characterised in that** the first data set (DS1) of sensor data is encoded by a first encoder (ENC1) of the hierarchical variational autoencoder (HVAE), wherein an image resolution of the first data set (DS1) is reduced by a predetermined factor, in particular 2⁴.

3. Computer-implemented method according to claim 2, **characterised in that** the first data set (DS1) of sensor data encoded by the first encoder (ENC1) is divided into the first hierarchical level (E1) and the second hierarchical level (E2), wherein the first data set (DS1) of sensor data in the first hierarchical level (E1) is encoded by a second encoder (ENC2) of the hierarchical variational autoencoder (HVAE), wherein an image resolution of the first data set (DS1) is reduced by a predetermined factor, in particular 2².

4. Computer-implemented method according to Claim 3, **characterized in that** the first data set (DS1), encoded by the second encoder (ENC2) to form a first feature vector (MV1), of sensor data is assigned to the first codebook vector (CBV1) by a first autoregressive artificial neural network (KNN1), in particular an artificial convolutional neural network, of the first hierarchical level (E1), which has a smallest distance from the first feature vector (MV1).

5. Computer-implemented method according to Claim 4, **characterized in that** the first codebook vector (CBV1) is decoded by a first decoder (DEC1) of the hierarchical variational autoencoder (HVAE), wherein the image resolution of the first codebook vector (CBV1) is increased by a predetermined factor, in particular 2².

6. Computer-implemented method according to Claim 5, **characterized in that** the first data record (DS1) output by the first decoder (DEC1) of the first hierarchical level (E1) is merged with the first data record (DS1) on the second hierarchical level (E2) encoded by the first encoder (ENC1) of the hierarchical variational autoencoder (HVAE) to form the resulting third feature vector (MV3).

7. Computer-implemented method according to Claim 6, **characterized in that** the resulting third feature vector (MV3) is assigned to the second codebook vector (CBV2) by a second autoregressive artificial neural network (KNN2), in particular an artificial convolutional neural network, of the second hierarchical level (E2), which has a smallest distance from the resulting third feature vector (MV3).

8. Computer-implemented method according to one of the preceding claims, **characterized in that** the second data set (DS2) of sensor data of the environment detection sensor of the vehicle is encoded on the third hierarchical level (E3) by a third encoder (ENC3), wherein an image resolution of the second data set (DS2) is reduced by a predetermined factor, in particular 2⁸.

9. Computer-implemented method according to Claim 8, **characterized in that** the second dataset (DS2) of sensor data coded by the third encoder (ENC3) to form a fourth feature vector (MV4) is assigned by a third autoregressive artificial neural network (KNN3), in particular an artificial convolutional neural network, to the third hierarchical level (E3) to a third codebook vector (CBV3) which has a smallest distance from the fourth feature vector (MV4) of the second dataset (DS2).

10. Computer-implemented method according to Claim 9, **characterized in that** the third codebook vector (CBV3) is decoded by a second decoder (DEC2) of the hierarchical variational autoencoder (HVAE) or the external variational autoencoder, wherein the second data set (DS2) output by the second decoder (DEC2) conditions the first feature vector (MV1) encoded by the variational autoencoder (VAE1) of the first hierarchical level (E1) and the second feature vector (MV2) encoded by the variational autoencoder (VAE2) of the second hierarchical level (E2).

11. Computer-implemented method according to one of the preceding claims, **characterized in that** the first feature vector (MV1) encoded by the variational autoencoder (VAE1) of the first hierarchical level (E1) and the second feature vector (MV2) encoded by the variational autoencoder (VAE2) of the second hierarchical level (E2) are conditioned with a dataset identification (K), wherein the dataset identification (K) designates whether the sensor data is synthetically generated or actually acquired sensor data (SSD, RSD).

12. System (1) for generating synthetic sensor data (SSD) having superimposed distance and intensity information (11, 12) from an environment detection sensor, in particular a LiDAR sensor, of a vehicle, having:
a hierarchical variational autoencoder (HVAE) which has a first hierarchical level (E1), a second hierarchical level (E2) and a third hierarchical level (E3) or is configured to, Communication with the third hierarchical level (E3) of an external variational autoencoder, wherein the hierarchical variational autoencoder (HVAE) is set up to communicate with a first data record (DS1) of sensor data having distance information (11), In particular, synthetically produced and/or actually recorded sensor data (SSD, RSD) of the surroundings detection sensor of the vehicle by a variational autoencoder (VAE1) of the first hierarchical level (E1), which global features (GM) of the first data set (DS 1) of sensor data assign to a first codebook vector (CBV 1), where the global features (GM) represent objects contained in the sensor data that are recognized as such, wherein the hierarchical variational autoencoder (HVAE) is configured to receive, receiving the first data set (DS 1) of sensor data of the environment detection sensor of the vehicle by a variational autoencoder (VAE 2) of the second hierarchical level (E 2) which associates local features (LM) of the first data set (DS 1) of sensor data with a second codebook vector (CBV 2), where the local features (LM) represent fine features of the objects contained in the sensor data, wherein the hierarchical variational autoencoder (HVAE) is configured to condition a first feature vector (MV1) encoded by the variational autoencoder (VAE1) of the first hierarchical level (E1) and a second feature vector (MV2) encoded by the variational autoencoder (VAE2) of the second hierarchical level (E2) with a second data set (DS2) comprising distance and intensity information (I1, 12) of sensor data of the environment detection sensor of the vehicle, wherein the hierarchical variational autoencoder (HVAE) is configured to combine the conditioned first feature vector (MV1) and the conditioned second feature vector (MV2) into a resulting third feature vector (MV3), and wherein the hierarchical variational autoencoder (HVAE) is configured to combine the conditioned first feature vector (MV1) and the conditioned second feature vector (MV2), decoding the resulting third feature vector (MV3) for generating a third data set (DS3), having superimposed distance and intensity information (I1, 12), of synthetic sensor data (SSD) of the environment detection sensor of the vehicle.

13. Computer program having program code for carrying out the method according to one of Claims 1 to 11 when the computer program is executed on a computer.

14. A computer readable medium having program code of a computer program for performing the method of any one of claims 1 to 11 when said computer program is executed on a computer.

## Revendications

1. Procédé mis en oeuvre par ordinateur pour générer des données de capteur synthétiques (SSD) ayant des informations de distance et d'intensité superposées (I1, I2) d'un capteur de détection d'environnement, en particulier un capteur LiDAR, d'un véhicule, avec les étapes : Fournir (S1) un auto-encodeur variationnel hiérarchique (HVAE), qui a un premier niveau hiérarchique (E1), un deuxième niveau hiérarchique (E2) et un troisième niveau hiérarchique (E3) ou est configuré pour le faire, avec le troisième niveau hiérarchique (E3) d'un auto-encodeur variationnel externe pour communiquer ;
Réception (S2) d'un premier ensemble de données (DS1) contenant des informations de distance (I1) de données de capteur, en particulier de données de capteur générées synthétiquement et/ou réellement enregistrées (SSD, RSD), du capteur de détection d'environnement du véhicule par un capteur variationnel un auto-encodeur (VAE1) du premier niveau hiérarchique (E1), qui attribue des caractéristiques globales (GM) du premier ensemble de données (DS1) de données de capteur à un premier vecteur de livre de code (CBV1), où les caractéristiques globales (GM) représentent des objets contenus dans les données de capteur et reconnus comme tels ;
Réception (S3) du premier ensemble de données (DS1) de données de capteur du capteur de détection d'environnement du véhicule par un auto-encodeur variationnel (VAE2) du deuxième niveau hiérarchique (E2), qui attribue des caractéristiques locales (LM) du premier ensemble de données ( DS1) de données de capteur à un deuxième vecteur de livre de codes (CBV2) attribue, les caractéristiques locales (LM) représentant des caractéristiques fines des objets contenus dans les données de capteurs;
Conditionnement (S4) d'un premier vecteur caractéristique (MV1) codé par l'auto-encodeur variationnel (VAE1) du premier niveau hiérarchique (E1) et d'un deuxième vecteur caractéristique (MV2) codé par l'auto-encodeur variationnel (VAE2) du deuxième niveau hiérarchique ( E2) avec une distance et un deuxième ensemble de données (DS2) de données de capteur du capteur de détection d'environnement du véhicule ayant des informations d'intensité (I1, I2) ;
fusionner (S5) le premier vecteur caractéristique conditionné (MV1) et le second vecteur caractéristique conditionné (MV2) pour former un troisième vecteur caractéristique résultant (MV3);
et Décodage (S6) du troisième vecteur caractéristique résultant (MV3) pour générer un troisième ensemble de données (DS3) de données de capteur synthétiques (SSD) du capteur de détection d'environnement du véhicule qui a superposé des informations de distance et d'intensité (I1, I2).

2. Procédé mis en oeuvre par ordinateur selon la revendication 1, **caractérisé en ce que** le premier ensemble de données (DS1) de données de capteur est codé par un premier encodeur (ENC1) de l'auto-encodeur variationnel hiérarchique (HVAE), avec une résolution d'image du premier ensemble de données (DS1) d'un facteur prédéterminé, notamment 2⁴, est réduite.

3. Procédé mis en oeuvre par ordinateur selon la revendication 2, **caractérisé en ce que** le premier ensemble de données (DS1) de données de capteur codées par le premier codeur (ENC1) est divisé en le premier niveau hiérarchique (E1) et le deuxième niveau hiérarchique (E2), le premier ensemble de données (DS1) de données de capteur dans le premier niveau hiérarchique (E1) est codé par un second codeur (ENC2) de l'auto-encodeur variationnel hiérarchique (HVAE), une résolution d'image du premier ensemble de données (DS1) étant réduite d'une facteur prédéterminé, en particulier 2².

4. Procédé mis en oeuvre par ordinateur selon la revendication 3, **caractérisé en ce que** le premier ensemble de données (DS1) de données de capteur codées par le deuxième codeur (ENC2) pour former un premier vecteur caractéristique (MV1) est traité par un premier réseau neuronal artificiel autorégressif (KNN1 ), en particulier un réseau de convolution neuronale artificielle, le premier niveau de hiérarchie (E1) est attribué au premier vecteur de livre de code (CBV1), qui a la plus petite distance par rapport au premier vecteur caractéristique (MV1).

5. Procédé mis en oeuvre par ordinateur selon la revendication 4, **caractérisé en ce que** le premier vecteur de dictionnaire de codes (CBV1) est décodé par un premier décodeur (DEC1) de l'autocodeur variationnel hiérarchique (HVAE), la résolution d'image du premier vecteur de dictionnaire de codes (CBV1) étant augmentée. d'un facteur prédéterminé , notamment 2², est augmenté.

6. Procédé mis en oeuvre par ordinateur selon la revendication 5, **caractérisé en ce que** le premier jeu de données (DS1) délivré par le premier décodeur (DEC1) du premier niveau hiérarchique (E1) a le premier jeu de données (DS1) codé par le premier codeur (ENC1 ) de l'auto-encodeur variationnel hiérarchique (HVAE) DS1) est fusionné au deuxième niveau hiérarchique (E2) pour former le troisième vecteur de caractéristique résultant (MV3).

7. Procédé mis en oeuvre par ordinateur selon la revendication 6, **caractérisé en ce que** le troisième vecteur caractéristique résultant (MV3) est attribué au deuxième vecteur de dictionnaire de codes (CBV2) par un deuxième réseau neuronal artificiel autorégressif (KNN2), en particulier un réseau de convolution neuronale artificielle, de le deuxième niveau de hiérarchie (E2)., qui a une plus petite distance au troisième vecteur de caractéristique résultant (MV3).

8. Procédé mis en oeuvre par ordinateur selon l'une des revendications précédentes, **caractérisé en ce que** le deuxième ensemble de données (DS2) de données de capteur du capteur de détection d'environnement du véhicule est codé au troisième niveau hiérarchique (E3) par un troisième codeur (ENC3), avec une résolution d'image du deuxième ensemble de données (DS2) est réduite d'un facteur prédéterminé, en particulier 2⁸.

9. Procédé mis en oeuvre par ordinateur selon la revendication 8, **caractérisé en ce que** le deuxième ensemble de données (DS2) de données de capteur codées par le troisième codeur (ENC3) pour former un quatrième vecteur caractéristique (MV4) est traité par un troisième réseau neuronal artificiel autorégressif (KNN3 ), en particulier un réseau de convolution neuronale artificielle. Au troisième niveau hiérarchique (E3) est attribué un troisième vecteur de livre de codes (CBV3) qui a la plus petite distance par rapport au quatrième vecteur caractéristique (MV4) du deuxième ensemble de données (DS2).

10. Procédé mis en oeuvre par ordinateur selon la revendication 9, **caractérisé en ce que** le troisième vecteur de dictionnaire de codes (CBV3) est décodé par un deuxième décodeur (DEC2) de l'auto-encodeur variationnel hiérarchique (HVAE) ou de l'auto-encodeur variationnel externe, celui délivré par le deuxième décodeur ( DEC2). Le deuxième jeu de données (DS2) conditionne le premier vecteur de caractéristique (MV1) codé par l'auto-encodeur variationnel (VAE1) du premier niveau hiérarchique (E1) et le deuxième vecteur de caractéristique (MV2) codé par l'auto-encodeur variationnel (VAE2) de le deuxième niveau hiérarchique (E2).

11. Procédé mis en oeuvre par ordinateur selon l'une des revendications précédentes, **caractérisé en ce que** le premier vecteur caractéristique (MV1) codé par l'auto-encodeur variationnel (VAE1) du premier niveau hiérarchique (E1) et le deuxième vecteur caractéristique codé par l'auto-encodeur variationnel (VAE2 ) du deuxième niveau hiérarchique (E2) (MV2) sont conditionnés par un identificateur d'enregistrement de données (K), l'identificateur d'enregistrement de données (K) désignant si les données de capteur sont générées synthétiquement ou réellement enregistrées (SSD, RSD).

12. Système (1) de génération de données synthétiques de capteur (SSD) ayant des informations superposées de distance et d'intensité (I1, I2) d'un capteur de détection d'environnement, notamment un capteur LiDAR, d'un véhicule, avec :
un auto-encodeur variationnel hiérarchique (HVAE), qui a un premier niveau hiérarchique (E1), un deuxième niveau hiérarchique (E2) et un troisième niveau hiérarchique (E3) ou est configuré pour communiquer avec le troisième niveau hiérarchique (E3) d'un auto-encodeur variationnel, dans lequel l'auto-encodeur variationnel hiérarchique (HVAE) est configuré pour transmettre un premier ensemble de données (DS1) contenant des informations de distance (I1) de données de capteur, en particulier des données de capteur générées synthétiquement et/ou réellement enregistrées (SSD, RSD), du capteur de détection d'environnement du véhicule par un auto-encodeur variationnel (VAE1 ) le premier niveau de hiérarchie (E1), qui attribue des caractéristiques globales (GM) du premier ensemble de données (DS1) de données de capteur à un premier vecteur de livre de codes (CBV1), où les caractéristiques globales (GM) représentent des objets contenus dans les données de capteur et reconnus comme tels, le l'auto-encodeur variationnel hiérarchique (HVAE) étant configuré pour recevoir le premier ensemble de données (DS1) de données de capteur provenant du capteur de détection de l'environnement du véhicule par un auto-encodeur variationnel (VAE 2) le deuxième niveau de hiérarchie (E2), qui attribue des caractéristiques locales (LM) du premier ensemble de données (DS1) de données de capteur à un deuxième vecteur de dictionnaire de codes (CBV2), les caractéristiques locales (LM) représentant des caractéristiques fines des objets contenus dans les données de capteurs, pour recevoir l'auto-encodeur variationnel hiérarchique (HVAE) configuré pour générer un à travers le premier vecteur de caractéristique (MV1) codé par l'auto-encodeur variationnel (VAE1) du premier niveau hiérarchique (E1) et un second vecteur de caractéristique (MV2) codé par l'auto-encodeur variationnel (VAE2) du second niveau hiérarchique (E2) avec des informations de distance et d'intensité (I1, I2) ayant un deuxième ensemble de données (DS2) de données de capteur provenant du capteur de détection d'environnement du véhicule, l'auto-encodeur variationnel hiérarchique (HVAE) étant configuré pour convertir le premier vecteur de caractéristique conditionné (MV1) et le deuxième vecteur de caractéristique conditionné (MV2) en un troisième vecteur de caractéristique résultant (MV3) à fusionner, et dans lequel l'autoencodeur variationnel hiérarchique (HVAE) est agencé pour coder la résolution pour décoder le troisième vecteur caractéristique résultant (MV3) pour générer un troisième ensemble de données (DS3) de données de capteur synthétiques (SSD) du capteur de détection d'environnement du véhicule qui a superposé des informations de distance et d'intensité (I1, I2).

13. Programme informatique avec code de programme pour exécuter le procédé selon l'une quelconque des revendications 1 à 11 lorsque le programme informatique est exécuté sur un ordinateur.

14. Support de données lisible par ordinateur avec code de programme d'un programme informatique pour exécuter le procédé selon l'une des revendications 1 à 11 lorsque le programme informatique est exécuté sur un ordinateur.
